(19) Europäisches Patentamt / European Patent Office / Office européen des brevets

(11) **EP 3 563 164 B1**

(12) **EUROPEAN PATENT SPECIFICATION**

(45) Date of publication and mention
of the grant of the patent:
**17.06.2020   Bulletin 2020/25**

(51) Int Cl.:
*G01R 31/367* (2019.01)          *G01R 31/392* (2019.01)
*H01M 8/04537* (2016.01)          *H01M 8/04664* (2016.01)

(21) Application number: **17829041.7**

(22) Date of filing: **22.12.2017**

(86) International application number:
**PCT/IB2017/058353**

(87) International publication number:
**WO 2018/122715 (05.07.2018 Gazette 2018/27)**

(54) **SPECTRAL-BASED METHOD FOR FUEL CELL FAULTS DETECTION**

SPEKTRALES VERFAHREN ZUR ERKENNUNG VON BRENNSTOFFZELLENFEHLERN

PROCÉDÉ BASÉ SUR LE SPECTRE POUR LA DÉTECTION DE DÉFAUTS DE PILE À COMBUSTIBLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.12.2016   IT 201600131225**

(43) Date of publication of application:
**06.11.2019   Bulletin 2019/45**

(73) Proprietors:
• **Universitá Degli Studi Di Salerno**
**84084 Fisciano (IT)**
• **Commissariat à l'Énergie Atomique et aux Énergies Alternatives**
**75015 Paris (FR)**
Designated Contracting States:
**FR IT**

(72) Inventors:
• **POSTIGLIONE, Fabio**
**84084 Fisciano (SA) (IT)**
• **PIANESE, Cesare**
**84084 Fisciano (SA) (IT)**
• **MARRA, Dario**
**84084 Fisciano (SA) (IT)**
• **GUIDA, Maurizio**
**84084 Fisciano (SA) (IT)**
• **MOREL, Bertrand**
**75015 Paris (FR)**
• **LEFEBVRE-JOUD, Florence**
**75015 Paris (FR)**

(74) Representative: **IP Sextant s.r.l.**
**Via A. Salandra, n.18**
**00187 Rome (IT)**

(56) References cited:
EP-A1- 1 699 101          US-A- 5 790 413
US-A1- 2011 208 452          US-B1- 6 240 372

• Anonymous: "DESIGN: DEGRADATION SIGNATURES IDENTIFICATION FOR STACK OPERATION DIAGNOSTICS", , 15 February 2016 (2016-02-15), pages 1-12, XP055401689, Retrieved from the Internet: URL:http://cordis.europa.eu/result/rcn/177 527_en.pdf [retrieved on 2017-08-28]

**Description**

The present invention relates to a method for detecting faults and/or degradation in fuel cell assemblies, by analysing the power spectrum density (PSD) of the voltage signal output by a fuel cell assembly during steady-state operations. The method according to the present invention identifies specific faults and/or degradation signatures from specific patterns attained by the PSD of the measured voltage signal.

Estimation of power spectra is useful in a variety of applications, including the detection of signals buried in wide-band noise. Measured data are always affected by (wide-band) measurement noise representing a random process. The distribution over frequency of the power contained in a signal is expressed by the PSD. In general terms, one way of estimating the PSD of a signal is to simply find the Fast Fourier Transform, FFT, of the (equispaced) signal data and to appropriately scale the squared magnitude of the result.

Although the present invention is mainly directed towards the detection of faults and/or degradation concerning fuel utilization in solid-oxide fuel cell (SOFC) assemblies, it may be applied to any other faults causing frequency peaks in PSD due to electrochemical processes, different from those concerning fuel utilization, and to any other fuel cells technologies, besides SOFC assemblies, still remaining within the scope of protection as defined by the attached claims.

The wording "fuel cell assembly" will be used herein for both a single fuel cell and a system comprising at least one cell and other sub-systems and components (the so called Balance of Plant - BoP - sub-system).

Fuel cells are promising systems for the production of electricity due to their load-independent high electrical efficiency, their capability to exploit a wide range of fuels and to their capability to be easily assembled into a stack to satisfy different power requirements. They can be exploited in a large range of applications, from distributed generation to residential and industrial cogeneration, and to portable generation and traction. Furthermore, they provide power with lower fuel consumption and exhaust emissions with respect to other technologies.

However, they suffer from several problems including the membrane hydration and the degradation of their components, such as the membrane, the electrodes, and the gas diffusion layers, which compromise their performance. Hence, it is crucial to monitor the state of health of the fuel cell systems while operating. Many solutions have been proposed in the prior art.

As an example, document US 7531253 discloses a diagnostic tool for the monitoring of fuel cell stacks based on voltage drifts analysis through an analysis of the total harmonic distortion (THD), by superimposing a current periodic signal and evaluating the voltage signal harmonics. If an extra spectral component (i.e. harmonic distortion) occurs, critical conditions within the stack are detected.

Document US 2014/0093802 A1 discloses both a method and a system to diagnose faults and to control a fuel cell. The method consists in the application of alternating current (AC) signals to an individual fuel cell. The AC signals have a wide range of different frequencies. A voltage across the individual fuel cell is determined at each frequency, then an error is detected if the voltage differs from its reference value.

Document US 2007/0172708 A1 discloses a failure diagnosis method for a fuel cell assembly. The method deals with the evaluation of the impedance in a prescribed portion of a fuel cell assembly. A signal is obtained by superimposing an alternating current on the direct current generated from the fuel cell assembly. The estimated impedance is compared with a reference one, previously determined in standard operating conditions. Such comparison may lead to the detection of an abnormality in the prescribed portion of the fuel cell.

Document US 2007/0259256 A1 discloses systems and methods to determine the occurrence of a particular set of faults in electrochemical cells based on impedance measurements. The evaluation of the impedance signature with respect to a reference information allows the detection of several faults.

Document WO 2013/083873 A1 discloses a model-based diagnostic approach for the diagnosis of solid oxide cells. A model of the SOFC stack simulates the standard conditions that are compared with those measured in the real systems. The comparisons performed between the real system measurements and the model outputs permit to detect a deviation in SOFC assembly operations.

Document US 2006/0078788 A1 discloses a method for condition monitoring of a fuel cell stack, comprising several series-connected single cells, wherein a low-frequency current or voltage signal is impressed on the fuel cell stack. Then the resulting voltage or current signal is measured. At least one change of the harmonic content of the signal allows the inference of the current status of each cell of the stack. Anonymous, "Design: Degradation Signatures Identification for Stack Operation Diagnostics", 15 February 2016, pages 1-12, XP055401689, http://cordis.europa.eu/result/rcn/177527_en.pdf discloses a method for detecting faults and/or degradation in a fuel cell assembly by analysis of the power spectrum density of a voltage signal output by the fuel cell assembly during its steady-state operations.

However, prior art solutions suffer from a number of drawbacks. In fact, they require complex implementations for the system actively interacting with fuel cell assemblies (e.g., by injecting an external signal), and they are not completely reliable, increasing both device and measuring costs.

Therefore, it is an object of this invention to provide a method to evaluate the state of fuel cell assemblies during operation in a fully efficient, reliable, simple and inexpensive way, the results of which monitoring method may be used for diagnostic purposes.

It is specific subject-matter of the present invention a method for detecting faults and/or degradation a fuel cell assembly by analysis of the power spectrum density (PSD) of a voltage signal output by the fuel cell assembly during its steady-state operations, the method comprising the following steps:

acquiring a voltage signal output by the fuel cell assembly as a function of time;

identifying at least one voltage segment $s_i$ in the acquired voltage signal with $i= 1,..,n$, $n \in N$ and $n \geq 1$, each voltage segment $s_i$ being a collection of voltage measurements in a $i$-th time interval in which the fuel cell assembly is considered in a steady-state condition;

detrending each one of the at least one voltage segment $s_i$ to remove a slow-varying component, obtaining a de-trended voltage segment $s_i'$;

estimating the Power Spectrum Density (PSD) of each one of the at least one voltage segment $s_i'$ and its PSD peaks $P_k^i$ at characteristic frequencies $f_k$ of the fuel cell system assembly, with $k= 1,...,M$, $M \in N$ and $M \geq 1$;

computing a test statistic $T^i = T^i(P_k^i, R_k)$ for each one of the at least one voltage segment $s_i$, as a function of its PSD peaks magnitude values $P_k^i$ and of reference values $R_k$, each reference value $R_k$ being a magnitude of a peak at the characteristic frequency $f_k$ of the fuel cell assembly during normal steady-state operation;

checking whether the test statistic $T^i$ is greater than a predetermined threshold $\gamma$:

if the test statistic $T^i$ is lower than or equal to the predetermined threshold $\gamma$, recognising that the fuel cell assembly is in normal steady-state operation during the corresponding $i$-th time interval;

if the test statistic $T^i$ is greater than the predetermined threshold $\gamma$, recognising that fault/degradation occurred in the fuel cell system during the corresponding $i$-th time interval.

According to another aspect of the invention, the step of acquiring voltage signal output by the fuel cell assembly may use a sampling frequency not lower than 1/10 Hz, optionally equal to 1 Hz.

According to a further aspect of the invention, the step of identifying at least one voltage segment $s_i$ may be automatically performed through Change Detection Algorithms (CDAs).

According to an additional aspect of the invention, the length of the $i$-th time interval may be such that the corresponding voltage segment $s_i$, contains at least 1000 samples.

According to another aspect of the invention, the sampling frequency may be of 1 Hz and the length of the $i$-th time interval is not shorter than 1 h, optionally equal to 2h.

According to a further aspect of the invention, each one of the at least one de-trended voltage segment $s_i'$ may be obtained by subtracting from the voltage segment $s_i$, its Least Square Linear Fit, optionally through First differencing or Digital filtering.

According to an additional aspect of the invention, the characteristic frequencies $f_k$ and the reference values $R_k$, $\forall k$, may be obtained estimating a PSD of a de-trended voltage segment $s_j'$ in a $j$-th time interval in which the fuel cell assembly is assumed being in a normal steady-state operation and measuring its PSD peaks $P_k^j = R_k$ and the relative peak frequencies $f_k$, with $k= 1,...,M$, $M \in N$ and $M \geq 1$.

According to another aspect of the invention, the characteristic frequencies $f_k$ and the reference values $R_k$, $\forall k$, of a specific fuel cell assembly may be preliminarily obtained by performing steps from acquiring a voltage signal output to estimating the PSD on the fuel cell assembly operating in a steady-state condition after a warm up period, when it is assumed no substantial fault/degradation has yet occurred.

According to a further aspect of the invention, the characteristic frequencies $f_k$ and the reference values $R_k$, $\forall k$, of a first specific fuel cell assembly may be preliminarily obtained by performing steps from acquiring a voltage signal output to estimating the PSD on a second fuel cell assembly operating in a steady-state condition after a warm up period, when it is assumed no substantial fault/degradation has yet occurred, said second fuel cell assembly being of the same type of the first fuel cell assembly.

According to an additional aspect of the invention, the characteristic frequencies $f_k$ and the reference values $R_k$, $\forall k$, of a specific fuel cell assembly may be provided by manufacturer.

According to another aspect of the invention, the test statistic $T^i$ for each one of the at least one voltage segment

$s_i$, may be equal to

$$T_Q^i = \frac{\sum_{k=1}^{Q} P_k^i}{\sum_{k=1}^{Q} R_k},$$

with $Q \in N$ and $1 \leq Q \leq M$, where $Q$ is the number of peaks under consideration.

According to a further aspect of the invention, the test statistic $T^i$ for each one of the at least one voltage segment

$s_i$, may be equal to

$$T_g^i = g^i\left(T_{Q_1,Q_2}^i\right) = g\left(\frac{\sum_{k=1}^{Q_1} \beta_k P_k^i}{\sum_{h=1}^{Q_2} \rho_h R_h}\right)$$

with $Q_1, Q_2 \in N$, $1 \leq Q_1, Q_2 \leq M$, where $Q_1, Q_2$ are the numbers of peaks under consideration in the voltage segment and in the nominal steady-state condition, respectively (they can be different), while $\beta_k$ and $\rho_h$ are coefficients multiplying those PSD peaks values, and

$$T_{Q_1,Q_2}^i = \frac{\sum_{k=1}^{Q_1} \beta_k P_k^i}{\sum_{h=1}^{Q_2} \rho_h R_h}.$$

$g(\cdot)$ is any invertible function, optionally equal to

According to an additional aspect of the invention, the test statistic $T^i$ for each one of the at least one voltage

segment $s_i$, may be equal to

$$T_{Q_1,Q_2}^i = \sum_{k=1}^{Q_1} \vartheta_k P_k^i - \sum_{h=1}^{Q_2} \varphi_h R_h,$$

with $Q_1, Q_2 \in N$, $1 \leq Q_1, Q_2 \leq M$, where $Q_1, Q_2$ are the numbers of peaks under consideration in the voltage segments and in the nominal steady-state condition, respectively (they can be different), while $\vartheta_k$ and $\varphi_h$ are coefficients multiplying those PSD peaks values.

According to another aspect of the invention, the predetermined threshold y may be equal to a percentile 1 - $\alpha$ of the empirical distribution of the test statistic $T^i$ computed for a plurality of operations in nominal conditions, i. e. in normal steady-state operations, optionally a being equal to 0,05.

The main advantage of the present invention is that it involves a passive spectral analysis method, differently from the existing state of art involving active systems; this causes a decrease of complexity, and consequently manufacturing and maintenance costs, of the system implementing the diagnostic procedure for detecting faults and/or degradation in fuel cell assemblies.

The present invention will be now described, by way of illustration and not by way of limitation, according to its preferred embodiment, by particularly referring to the Figures of the annexed drawings, in which:

Fig. 1 is a schematic flow diagram of a preferred embodiment of the method for detecting faults and/or degradation of fuel cell assemblies according to the invention;
Fig. 2 shows a voltage signal measured in a specific test of the invention where different values of fuel utilization (FU) of a SOFC assembly are imposed to the SOFC assembly (Fig. 2a); a close-up of the voltage signal is also provided (Fig. 2b).
Fig. 3 shows the PSD spectra of the voltage signal of Figure 2, i.e. the PSD spectra of the voltage time series for different values of FU of Figure 2.

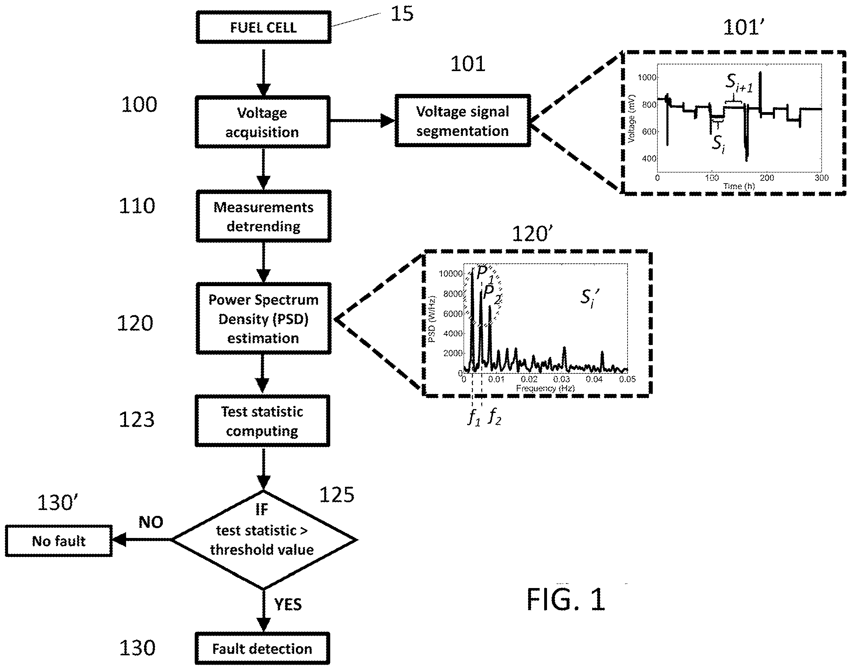

Referring to Fig. 1, the method of a preferred embodiment of the present invention starts at step 100 acquiring a voltage signal output by a fuel cell assembly 15 as a function of time, by using a sampling frequency not lower than 1/10 Hz optionally equal to 1 Hz. At step 101, the method identifies voltage segments $s_i$ in the acquired voltage signal, with $i = 1,...,n$, where n $\in$ N and $n \geq 1$, where each voltage segment $s_i$ is a collection of voltage measurements in the $i$-th time interval in which the fuel cell assembly can be considered in steady-state conditions. The transitions from one steady-state to another is characterized by an abrupt change in the voltage values that can be easily revealed. Optionally, the identification step 101 can be automatically performed through Change Detection Algorithms (CDAs). Graph 101' shown in Fig. 1 is a voltage signal output by a SOFC assembly obtained by testing the method of the present invention on the SOFC assembly varying its FU according to a preferred embodiment, as disclosed below. The voltage segments can be also consecutive if any abrupt change in the fuel cell assembly and in the voltage signal has occurred. The length of the $i$-th time interval must be selected by considering the trade-off between a quick detection (short intervals, strengthening also the assumption of steady-state conditions for the fuel cell assembly in the time interval), and the accuracy of the analysis to be performed in the next steps of the method according to the invention in the frequency domain, requiring long time intervals. In particular, the length of the $i$-th time interval is such that the corresponding voltage segment $s_i$, contains at least 1000 samples. For a sampling frequency of 1 Hz the length of the $i$-th time interval is optionally equal to 1 h, more optional equal to 2h. Longer voltage segments may be considered to reduce the bias of the PSD estimate and to increase spectral resolution, if the fuel cell assembly can be safely considered in steady-state operations. In order to highlight the dynamics at the (relatively) higher frequencies, a de-trending is performed at step 110 to remove the slow-varying component from each voltage segment $s_i$ as the frequency content of that component (very close to the frequency 0 Hz) may be assumed not useful. For each voltage segment $s_i$, the slow-varying component is identified and removed by subtracting the Least Square Linear Fit of data obtaining a de-trended segment $s_i'$. In other embodiments of the method according to the invention, de-trending can be performed through well-known techniques different from subtracting the Least Square Linear Fit, such as the First differencing or Digital filtering, still remaining within the scope of the invention. Then at step 120, each de-trended segment $s_i'$ output by step 110 is analysed in the frequency domain to estimate its PSD, obtaining a PSD graph 120' of each segment $s_i'$, and to measure its PSD peaks $P_k^i$ at characteristic frequencies $f_k$ with $k = 1,...,M$, $M \in N$ and $M \geq 1$. A peak is a local maximum present in the PSD of the segment $s_i'$. The characteristic frequencies $f_k$ depend on the specific fuel cell assembly 15 under investigation. A magnitude variation of at least one peak $P_k^i$ in respect to a corresponding reference value $R_k$ is adopted as a signature for faults/degradation detection. The reference values $R_k$ are the magnitude of peaks at characteristic frequencies $f_k$ of the specific fuel cell assembly 15 during a normal steady-state operation, i.e. the fuel cell assembly has not affected by fault/degradation. The values of the characteristic frequencies $f_k$ and of the reference values $R_k$, $\forall k$, depend on the specific type of the fuel cell assembly 15 under investigation; however, a characteristic frequency $f_1$ ($k = 1$) is typically within the range [10⁻³, 10⁻¹] Hz regardless of the fuel cell assembly, while the other characteristic frequencies $f_k$ ($k = 2, 3, ...$) are multiples of $f_1$ as it happens for the harmonic components of periodic signals corrupted by noise. In a preferred embodiment of the present invention, the values of the characteristic frequencies $f_k$ and of the reference values $R_k$, $\forall k$, of a specific fuel cell assembly 15 are obtained at step 120 estimating a PSD of a de-trended voltage segment $s_j'$ in a j-th time interval in which the fuel cell assembly is assumed being in a normal steady-state operation and measuring its PSD peaks $P_k^j = R_k$ and the relative peak frequencies $f_k$, $\forall k$. Optionally, values of the characteristic frequencies $f_k$ and of the reference values $R_k$, $\forall k$, of a specific fuel cell assembly 15 are preliminarily obtained by performing steps from 100 to 120 on the fuel cell assembly 15 operating in a normal steady-state condition after a warm up period, when it is assumed no substantial fault/degradation has yet occurred. More optionally, values of the characteristic frequencies $f_k$ and of the reference values $R_k$, $\forall k$, of a first specific fuel cell assembly 15 are preliminarily obtained by performing steps from 100 to 120 on a second fuel cell assembly 15' operating in a normal steady-state condition after a warm up period, said second fuel cell assembly 15' being of the same type of the first fuel cell assembly 15, when it is assumed no substantial fault/degradation has yet occurred. In other embodiments of the present invention, fuel cell manufacturer provides the values $f_k$ and $R_k$, $\forall k$. At step 123, the method computes a test statistic $T^i = T^i(P_k^i, R_k)$ for each voltage segment $s_i$, combining its PSD peaks values $(P_1^i, P_2^i, ...)$ and the reference values $(R_1, R_2, ...)$, i.e. $T^i = T^i(P_1^i, P_2^i, ..., R_1, R_2, ...)$. In step 125, it is checked whether the test statistic $T^i$ is greater than a predetermined threshold $\gamma$. If the test statistic $T^i$ is lower than or equal to the predetermined threshold $\gamma$, the flow continues through the "NO" branch from step 125, whereby the method according to the invention recognises (step 130') that the fuel cell assembly 15 is in a normal steady-state operation (namely, no fault/degradation occurred), and the method ends (or return to step 100). Alternatively, if the test statistic $T^i$ is greater than the predetermined threshold $\gamma$, the flow continues through the "YES" branch from step 125, whereby the method according to the invention recognises (step 130) that a fault/degradation occurred in the fuel cell system, and the method ends (or return to step 100). In a preferred embodiment of the present invention, given a false alarm probability $\alpha$, the value of the threshold $\gamma$ can be predetermined by the percentile $1 - \alpha$ of the empirical distribution of the statistic $T^i$ computed for a plurality of operations in nominal conditions, i.e. in normal steady-state operations, where the fluctuations of the statistic $T^i$ are due to measurement noise and small variations of the output voltage caused by small perturbations of the current density, of the temperature the cells and fuel, of the air and fuel flows, typically affecting real systems. In a preferred embodiment of this invention, the test statistic $T^i$ is written as $$T_Q^i = \frac{\sum_{k=1}^Q P_k^i}{\sum_{k=1}^Q R_k},$$ with $Q \in N$ and $1 \leq Q \leq M$, where $Q$ is the number of peaks under consideration. In a further embodiment, the test statistic $T^i$ is written as

$$T^i_{Q_1,Q_2} = {\sum_{k=1}^{Q_1} \beta_k P^i_k}\Big/{\sum_{h=1}^{Q_2} \rho_h R_h},$$

with $Q_1, Q_2 \in N$, $1 \leq Q_1, Q_2 \leq M$, where $Q_1, Q_2$ are the numbers of peaks under consideration in the voltage segment and in the normal steady-state condition, respectively (they can be different), while $\beta_k$ and $\rho_h$ are coefficients multiplying those PSD peaks values. In an additional embodiment, test statistic $T^i$ is written as

$$T^i_g = g\left(T^i_{Q_1,Q_2}\right) = g\left({\sum_{k=1}^{Q_1} \beta_k P^i_k}\Big/{\sum_{h=1}^{Q_2} \rho_h R_h}\right),$$

where $g(\cdot)$ is any invertible function. In a more further em-

bodiment, the test statistic $T^i$ is written as

$$\tau^i_{Q_1,Q_2} = \sum_{k=1}^{Q_1} \vartheta_k P^i_k - \sum_{h=1}^{Q_2} \varphi_h R_h,$$

with $Q_1, Q_2 \in N$, $1 \leq Q_1, Q_2 \leq M$, where $Q_1$, $Q_2$ are again the numbers of peaks under consideration in the voltage segments and in the normal steady-state condition, respectively, while $\vartheta_k$ and $\varphi_h$ are coefficients multiplying those PSD peaks values.

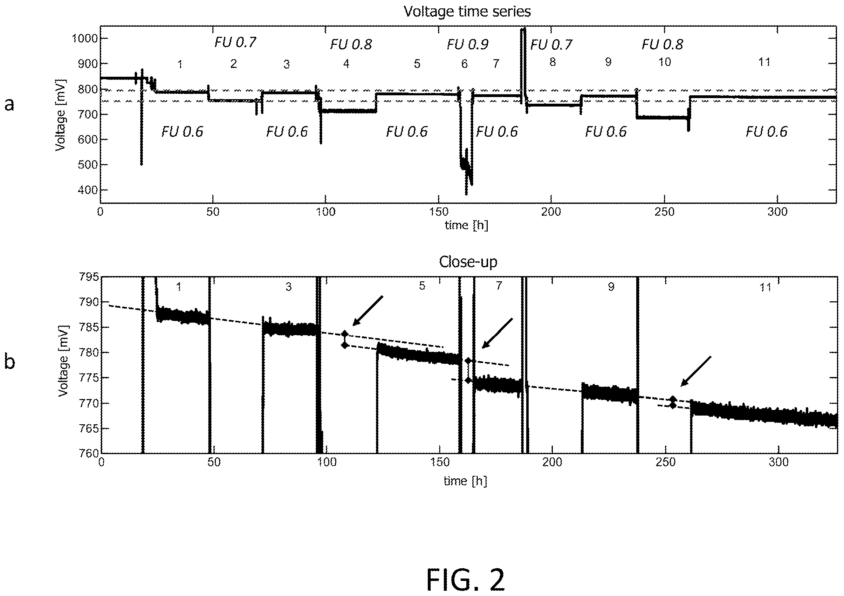

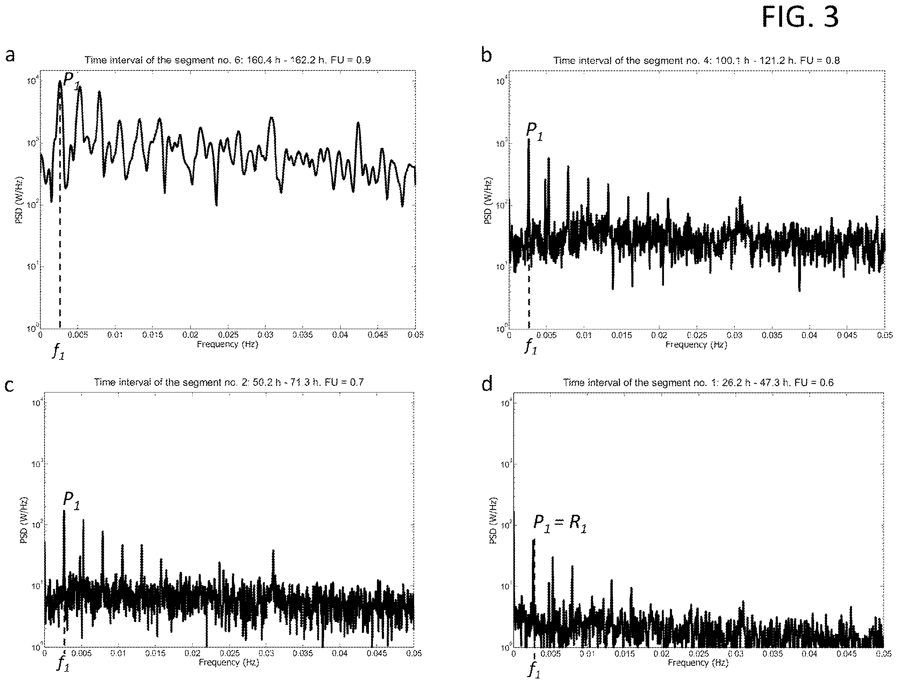

To verify the reliability of the method according to a preferred embodiment of the present invention, inventors conducted a test to detect faults in a SOFC assembly 15 during its operation while varying FU parameter. After a warm up period (not considered in the method), FU was varied from the nominal value FU = 0.6 up to 0.7, 0.8, 0.9. The nominal value of FU depends on the specific fuel cell assembly under analysis, but it may change for different fuel cell assemblies. Starting from the nominal value, the analysis was performed for higher values of FU, since these conditions may induce a fault in the assembly. A first sequence {FU} of FU parameter values was {0.6; 0.7; 0.6; 0.8; 0.6; 0.9; 0.6; 0.7; 0.6; 0.8; 0.6}. The testing procedure was designed to induce high FU by varying both inlet gas flow rate (in the first part of the testing procedure) and current density (the last 0.7 and 0.8 FU values) keeping fixed the other control variables/parameters. With reference to Figs. 2 and 3, the method started acquiring (step 100 of Fig. 1) the SOFC assembly voltage signal in mV as a function of time t up to more than 300 hours.

Then, inventors identified (step 101 of Fig. 1) voltage segments $s_i$ in the acquired voltage signal in time domain, with $i = 1,...,n$, $n \in N$, by visual inspection. The transitions from one steady-state to another are characterized by an abrupt change in the voltage values that can be easily revealed by change detection algorithms. In two hours after the abrupt change, the voltage measurements have a new almost linear behaviour and can be considered representative of a new steady-state operating condition, with typically a new FU value. Such a voltage signal segmentation results in a second sequence {$s_i$} of voltage segments {1; 2; 3; 4; 5; 6; 7; 8; 9; 10; 11} corresponding to the first sequence {FU}. Fig. 2a shows the resulting voltage signal waveform (101') with segmentation as a function of FU. The length of the voltage segments is chosen as large as possible in order to increase the accuracy of the PSD estimates and the data point corresponding to a FU variation, i.e. corresponding to non-stationary state operation of the SOFC assembly, were neglected. The inventors noted that voltage decreased almost linearly in every voltage segment $s_i$, as shown in Fig. 2b for voltage segments {1; 3; 5; 7; 9; 11} corresponding to FU=0.6. No evident difference was present among decreasing rates of all voltage segments $s_i$ but that related to FU = 0.9, where a fault occurs (see Fig. 2a). Thus, the inventors have ascertained that decreasing rates cannot be considered as signature of fuel cell faults/degradation or, on the other hand, that the decreasing rate seems not meaningful to detect FU changes. However, drops were evident in the voltage signal, after higher fuel utilization operations (as indicated by arrow in Fig. 2b), highlighting that an accelerated degradation mechanism has occurred.

To remove the voltage decrease component, i.e. the slow-varying component, a linear model for each voltage segment $s_i$ is assumed by adopting Least Square Estimation procedures and subtracted from the related experimental data resulting in a third sequence of de-trended voltage segments {$s_i'$} (step 110 of Fig. 1). Finally, the inventors estimated (step 120 of Fig. 1) the PSD of each de-trended segment $s_i'$ obtaining a corresponding PSD spectrum (as shown in the graph 120' of Fig. 1).

For clarity, only PSD analysis of four segments are herein described summarizing results and conclusions on the analysis of the whole set {$s_i'$} of segments. Figs. 3a, 3b, 3c, 3d show PSD spectra of de-trended segments {6, 4, 2, 1} for time intervals of {(160.4h - 162.2h); (100.1h - 121.2h); (50.2h - 71.3h); (26.2h - 47.3h)} respectively. Each segment of the set {6, 4, 2, 1} corresponds to a different FU, namely in the set {0.9, 0.8, 0.7, 0.6} respectively. All spectra show peaks $P_k$ in W/Hz at frequencies $f_k$ of about k/380 Hz, for k = 1, 2, 3, ..., n. The magnitude of the peaks $P_k$ for FU = 0.6 are set equal to the reference values $R_k$, since it is the period in which the fuel cell assembly 15 under analysis is in normal condition after the warm up period. This behaviour of the PSDs underlines the presence of a periodic component with a period $T$ within the voltage time segments, which for the SOFC assembly of the testing is of about 380 s. Such a period $T$ is specific for the SOFC assembly under investigation. As shown in Fig. 3, the PSD peak magnitude at the frequency of 1/380 Hz is related to the FU value; also the multiples follow the same trend. In particular, PSD peak magnitude increases with FU. The evidence on the PSD behaviour for different values of FU suggests that PSD peak(s) magnitude of the de-trended voltage time segments can be adopted as a signature for high FU faults. For instance, given a false alarm $\alpha$ = 0.05 and considering only the first PSD peak for the test statistic (i.e. $M$ = 1), the value of threshold can be determined by computing the empirical distribution of values $T_1 = P_1/R_1$ measured during operations where the FU = 0.6. By setting the threshold y = 2, the test $T_1 > \gamma$ is able to detect every high FU faults, namely FU = 0.7, FU = 0.8 and FU = 0.9, for the particular SOFC assembly 15 under test.

The preferred embodiment of this invention has been described, but it should be understood that those skilled in the art can make other variations and changes, without so departing from the scope of protection thereof, as defined by the attached claims.

**Claims**

1. Method for detecting faults and/or degradation in a fuel cell assembly by analysis of the power spectrum density (PSD) of a voltage signal output by the fuel cell assembly during its steady-state operations, the method comprising the following step:

   acquiring (100) a voltage signal output by the fuel cell assembly (15) as a function of time;
   the method being **characterized by** comprising the following steps:

   identifying (101) at least one voltage segment $s_i$ in the acquired voltage signal with $i= 1,...,n$, $n \in$ N and $n \geq 1$, each voltage segment $s_i$ being a collection of voltage measurements in a $i$-th time interval in which the fuel cell assembly is considered in a steady-state condition;
   detrending (110) each one of the at least one voltage segment $s_i$ to remove a slow-varying component, obtaining a de-trended voltage segment $s_i$';
   estimating (120) the Power Spectrum Density, PSD, of each one of the at least one voltage segment $s_i$'

   and its PSD peaks $P_k^i$ at characteristic frequencies $f_k$ of the fuel cell system assembly, with $k= 1,...,M$, $M \in$ N and $M \geq 1$;

   computing (123) a test statistic $T^i = T^i(P_k^i, R_k)$ for each one of the at least one voltage segment $s_i$,

   as a function of its PSD peaks magnitude values $P_k^i$ and of reference values $R_k$, each reference value $R_k$ being a magnitude of a peak at the characteristic frequency $f_k$ of the fuel cell assembly (15) during normal steady-state operation;
   checking (125) whether the test statistic $T^i$ is greater than a predetermined threshold $\gamma$:

   if the test statistic $T^i$ is lower than or equal to the predetermined threshold $\gamma$, recognising (130') that the fuel cell assembly (15) is in normal steady-state operation during the corresponding $i$-th time interval;
   if the test statistic $T^i$ is greater than the predetermined threshold $\gamma$, recognising (130) that fault and/or degradation occurred in the fuel cell system during the corresponding $i$-th time interval.

2. Method according to claim 1, wherein the step (100) of acquiring voltage signal output by the fuel cell assembly (15) uses a sampling frequency not lower than 1/10 Hz, optionally equal to 1 Hz.

3. Method according to claim 1 or 2, wherein the step (101) of identifying (101) at least one voltage segment $s_i$ is automatically performed through Change Detection Algorithms (CDAs).

4. Method according to any of the previous claims, wherein the length of the $i$-th time interval is such that the corresponding voltage segment $s_i$ contains at least 1000 samples.

5. Method according to claim 2 and 4, wherein the sampling frequency is of 1 Hz and the length of the $i$-th time interval is not shorter than 1 h, optionally equal to 2h.

6. Method according to any of previous claims, wherein each one of the at least one de-trended voltage segment $s_i$' is obtained by subtracting from the voltage segment $s_i$ its Least Square Linear Fit, optionally through First differencing or Digital filtering.

7. Method according to any of previous claims, wherein the characteristic frequencies $f_k$ and the reference values $R_k$, $\forall$k, are obtained estimating (120) a PSD of a de-trended voltage segment $s_j'$ in a *j-th* time interval in which the fuel cell assembly is assumed being in a normal steady-state operation and measuring (120) its PSD peaks $P_k^j = R_k$ and the relative peak frequencies $f_k$, with *k= 1,...,M, M $\in$ N* and *M $\geq$ 1*.

8. Method according to any of claims 1 to 6, wherein the characteristic frequencies $f_k$ and the reference values $R_k$, $\forall$k, of a specific fuel cell assembly (15) are preliminarily obtained by performing steps from acquiring (100) a voltage signal output to estimating (120) the PSD on the fuel cell assembly (15) operating in a steady-state condition after a warm up period, when it is assumed no substantial fault and/or degradation has yet occurred.

9. Method according to any of claims 1 to 6, wherein the characteristic frequencies $f_k$ and the reference values $R_k$, $\forall$k, of a first specific fuel cell assembly (15) are preliminarily obtained by performing steps from acquiring (100) a voltage signal output to estimating (120) the PSD on a second fuel cell assembly (15') operating in a steady-state condition after a warm up period, when it is assumed no substantial fault and/or degradation has yet occurred, said second fuel cell assembly (15') being of the same type of the first fuel cell assembly (15).

10. Method according to any of claims 1 to 6, wherein the characteristic frequencies $f_k$ and the reference values $R_k$, $\forall$k, of a specific fuel cell assembly (15) are provided by manufacturer.

11. Method according to any of previous claims, wherein the test statistic $T^i$ for each one of the at least one voltage segment $s_i$, is equal to $$T_Q^i = \frac{\sum_{k=1}^{Q} P_k^i}{\sum_{k=1}^{Q} R_k},$$ with $Q \in N$ and $1 \leq Q \leq M$, where $Q$ is the number of peaks under consideration.

12. Method according to any of claims 1 to 10, wherein the test statistic $T^i$ for each one of the at least one voltage segment $s_i$, is equal to $$T_g^i = g^i\big(T_{Q_1,Q_2}^i\big) = g\left(\frac{\sum_{k=1}^{Q_1} \beta_k P_k^i}{\sum_{h=1}^{Q_2} \rho_h R_h}\right)$$ with $Q_1$, $Q_2 \in N$, $1 \leq Q_1$, $Q_2 \leq M$, where $Q_1$, $Q_2$ are the numbers of peaks under consideration in the voltage segment and in the nominal steady-state condition, respectively, while $\beta_k$ and $\rho_h$ are coefficients multiplying those PSD peaks values, and $g(\cdot)$ is any invertible function, optionally equal to $$T_{Q_1,Q_2}^i = \frac{\sum_{k=1}^{Q_1} \beta_k P_k^i}{\sum_{h=1}^{Q_2} \rho_h R_h}.$$

13. Method according to any of claims 1 to 10, wherein the test statistic $T^i$ for each one of the at least one voltage segment $s_i$, is equal to $T_{Q_1,Q_2}^i = \sum_{k=1}^{Q_1} \vartheta_k P_k^i - \sum_{h=1}^{Q_2} \varphi_h R_h,$ with $Q_1$, $Q_2 \in N$, $1 \leq Q_1$, $Q_2 \leq M$, where $Q_1$, $Q_2$ are the numbers of peaks under consideration in the voltage segments and in the nominal steady-state condition, respectively, while $\vartheta_k$ and $\varphi_h$ are coefficients multiplying those PSD peaks values.

14. Method according to any of previous claims, wherein the predetermined threshold $\gamma$ is equal to a percentile 1 - $\alpha$ of the empirical distribution of the test statistic $T^i$ computed for a plurality of operations in nominal conditions, i. e. in normal steady-state operations, optionally $\alpha$ being equal to 0,05.

**Patentansprüche**

1. Verfahren zum Detektieren von Fehlern und/oder Degradierung in einer Brennstoffzellenanordnung durch Analyse der Leistungsspektrumsdichte (PSD, "Power Spectrum Density") eines Spannungssignal-Ausgangs durch die Brennstoffzellenanordnung während deren stationären Betriebs, wobei das Verfahren die folgenden Schritt umfasst:

Erfassen (100) eines Spannungssignal-Ausgangs durch die Brennstoffzellenanordnung (15) als eine zeitabhängige Funktion;
wobei das Verfahren durch Folgendes gekennzeichnet ist:

Identifizieren (101) mindestens eines Spannungssegments $s_i$ in dem erfassten Spannungssignal mit $i=1,...,n$, $n \in N$ und $n \geq 1$, wobei jedes Spannungssegment $s_i$ eine Reihe von Spannungsmessungen in einem $i$-ten Zeitintervall ist, in dem eine stationäre Bedingung für die Brennstoffzellenanordnung angenommen wird;
Tendenz-Beseitigen (110) eines jeden des mindestens einen Spannungssegments $s_i$, um eine langsam variierende Komponente zu entfernen, wodurch ein Spannungssegment ohne Tendenz $s_i'$ erhalten wird;
Abschätzen (120) der Leistungsspektrumsdichte, PSD, eines jeden des mindestens einen Spannungssegments $s_i'$ und deren PSD-Spitzen $P_k^i$ bei charakteristischen Frequenzen $f_k$ der Brennstoffzellenanordnung, wobei $k=1,...,M$, $M \in N$ und $M \geq 1$;
Ausrechnen (123) einer Test-Statistik $T^i=T^i(P_k^i, R_k)$ für jedes des mindestens einen Spannungssegments $s_i$ als Funktion von dessen PSD-Spitzen-Amplitudenwerten $P_k^i$ und von Referenzwerten $R_k$, wobei jeder Referenzwert $R_k$ eine Amplitude eines Spitzenwertes bei der charakteristischen Frequenz $f_k$ der Brennstoffzellenanordnung bei normalem stationären Betrieb ist;
Prüfen (125) ob die Test-Statistik $T^i$ größer als eine vorbestimmte Schwelle $\gamma$ ist:

wenn die Test-Statistik $T^i$ niedriger als oder gleich wie die vorbestimmte Schwelle $\gamma$ ist, Erkennen (130'), dass die Brennstoffzellenanordnung (15) während des entsprechenden i-ten Zeitintervalls in einem normalen stationären Betrieb ist;
wenn die Test-Statistik $T^i$ größer als die vorbestimmte Schwelle ist, Erkennen (130), dass Fehler oder Degradierung in der Brennstoffzellenanordnung während des entsprechenden i-ten Zeitintervalls stattgefunden haben.

2. Verfahren nach Anspruch 1, wobei der Schritt (100) des Ermittelns eines Spannungssignal-Ausgangs durch die Brennstoffzellenanordnung (15) eine Abtastfrequenz verwendet, die nicht niedriger als 1/10 Hz ist, optional gleich 1 Hz ist.

3. Verfahren nach Anspruch 1 oder 2, wobei der Schritt (101) des Identifizierens (101) von mindestens einem Spannungssegment $s_i$ durch Änderungserkennungsalgorithmen (Change Detection Algorithms, CDAs) automatisch ausgeführt wird.

4. Verfahren nach einem der vorhergehenden Ansprüche, wobei die Länge des $i$-ten Zeitintervalls so ist, dass das entsprechende Spannungssegment $s_i$ mindestens 1000 Muster enthält.

5. Verfahren nach Anspruch 2 und 4, wobei die Abtastfrequenz 1 Hz ist und die Länge des $i$-ten Zeitintervalls nicht kürzer als 1 Stunde, optional gleich 2 Stunden ist.

6. Verfahren nach einem der vorhergehenden Ansprüche, wobei jedes des mindestens einen Spannungssegments ohne Tendenz $s_i'$ dadurch erhalten wird, dass dem Spannungssegment $s_i$ dessen kleinste lineare Anpassung (Least Square Linear Fit) abgezogen wird, optional durch erste Differenzierung (First Differencing) oder digitale Filterung (Digital Filtering).

7. Verfahren nach einem der vorhergehenden Ansprüche, wobei die charakteristischen Frequenzen $f_k$ und die Referenzwerte $R_k$, $\forall k$, durch Folgendes ermittelt werden: Abschätzen (120) eines PSD eines Spannungssegments ohne Tendenz $s_i'$ in einem $j$-ten Zeitintervall, in dem ein normaler stationärer Betrieb für die Brennstoffzellenanordnung angenommen wird, und Messen (120) dessen PSD-Spitzen $P_k^j = R_k$ und der relativen Spitz-Frequenzen $f_k$, wobei $k = 1,...,M$, $M \in N$ und $M \geq 1$.

8. Verfahren nach einem der Ansprüche 1 bis 6, wobei die charakteristischen Frequenzen $f_k$ und die Referenzwerte $R_k$, $\forall k$, einer bestimmten Brennstoffzellenanordnung (15) durch Ausführen von Schritten von dem Ermitteln (100) eines Spannungssignals bis zum Abschätzen (120) des PSD auf der Brennstoffzellenanordnung (15), die nach einer Aufwärmungsperiode bei einer stationären Bedingung betrieben wird, vorläufig ermittelt werden, wenn angenommen wird, dass noch keine Fehler und/oder Degradierung stattgefunden haben.

9. Verfahren nach einem der Ansprüche 1 bis 6, wobei die charakteristischen Frequenzen $f_k$ und die Referenzwerte $R_k$, $\forall$ $k$ einer ersten spezifischen Brennstoffzellenanordnung (15) durch Ausführen von Schritten von dem Ermitteln (100) eines Spannungssignals bis zum Abschätzen (120) des PSD auf einer zweiten Brennstoffzellenanordnung (15'), die nach einer Aufwärmungsperiode bei einer stationären Bedingung betrieben wird, vorläufig ermittelt werden, wenn angenommen wird, dass noch keine Fehler und/oder Degradierung stattgefunden haben, wobei die zweite Brennstoffzellenanordnung (15') vom selben Typ wie die erste Brennstoffzellenanordnung (15) ist.

10. Verfahren nach einem der Ansprüche 1 bis 6, wobei die charakteristischen Frequenzen $f_k$ und die Referenzwerte $R_k$, $\forall$ $k$ einer spezifischen Brennstoffzellenanordnung (15) von einem Hersteller bereitgestellt werden.

11. Verfahren nach einem der vorhergehenden Ansprüche, wobei die Test-Statistik $T^i$ für jedes des mindestens einen Spannungssegments $s_i$ gleich $T_Q^i = \sum_{k=1}^{Q} P_k^i / \sum_{k=1}^{Q} R_k$ ist, mit $Q \in N$ und $1 \leq Q \leq M$, wobei Q die Anzahl der betrachteten Spitzen ist.

12. Verfahren nach einem der Ansprüche 1 bis 10, wobei die Test-Statistik $T^i$ für jedes des mindestens einen Spannungssegments $s_i$ gleich $T_g^i = g^i\left(T_{Q_1,Q_2}^i\right) = g\left(\sum_{k=1}^{Q_1} \beta_k P_k^i / \sum_{h=1}^{Q_2} \rho_h R_h\right)$ ist, mit $Q_1, Q_2 \in N$ und $1 \leq Q_1$, $Q_2 \leq M$, wobei $Q_1$, $Q_2$ jeweils die Anzahlen der betrachteten Spitzen in dem Spannungssegment und der nominalen stationären Bedingung sind, wobei $\beta_k$ und $\rho_h$ Koeffizienten sind, die jene PSD-Spitzenwerte multiplizieren, und g($\cdot$) eine beliebige invertierbare Funktion ist, die optional $T_{Q_1,Q_2}^i = \sum_{k=1}^{Q_1} \beta_k P_k^i / \sum_{h=1}^{Q_2} \rho_h R_h$ gleicht.

13. Verfahren nach einem der Ansprüche 1 bis 10, wobei die Test-Statistik $T^i$ für jedes des mindestens einen Spannungssegments $s_i$ gleich $T_{Q_1,Q_2}^i = \sum_{k=1}^{Q_1} \vartheta_k P_k^i - \sum_{h=1}^{Q_2} \varphi_h R_h$ ist, mit $Q_1, Q_2 \in N$ und $1 \leq Q_1$, $Q_2 \leq M$, wobei $Q_1$, $Q_2$ jeweils die Anzahlen der betrachteten Spitzen in dem Spannungssegment und der nominalen stationären Bedingung sind, wobei $\vartheta_k$ und $\varphi_h$ Koeffizienten sind, die jene PSD-Spitzenwerte multiplizieren.

14. Verfahren nach einem der vorhergehenden Ansprüche, wobei die vorbestimmte Schwelle $\gamma$ einem ($1-\alpha$)-Quantil der empirischen Distribution der Test-Statistik $T^i$ ist, die für eine Vielzahl von Vorgängen unter normalen Bedingungen ausgerechnet wird, d.h. bei normalen stationären Vorgängen, wobei $\alpha$ optional 0,05 gleicht.

## Revendications

1. Procédé de détection de défauts et/ou de dégradation dans un ensemble de pile à combustible par analyse de la densité Spectrale de puissance (PSD) d'un signal de tension émis par l'ensemble de pile à combustible pendant ses opérations en régime permanent, le procédé comprenant le étape suivante :

une acquisition (100) d'un signal de tension émis par l'ensemble de pile à combustible (15) en fonction du temps ; le procédé étant **caractérisé en ce qu'**il comprend les étapes suivantes :

une identification (101) d'au moins un segment de tension $s_i$ dans le signal de tension acquis avec $i= 1, ..., n$, $n \in N$ et $n \geq 1$, chaque segment de tension $s_i$ étant une collection de mesures de tension dans un $i$-ème intervalle de temps pendant lequel l'ensemble de pile à combustible est considéré en régime permanent ; un redressement (110) de chacun de l'au moins un segment de tension $s_i$ pour éliminer une composante à variation lente, obtenant un segment de tension redressé $s_i'$ ; une estimation (120) de la Densité Spectrale de Puissance, PSD, de chacun de l'au moins un segment de tension $s_i'$ et de ses pics PSD $P_k^i$ aux fréquences caractéristiques $f_k$ de l'ensemble de système de pile à combustible, avec $k=1,..., M, M \in N$ et $M \geq 1$ ;

$$T^i = T^i (P_k^i , R_k)$$

un calcul (123) d'une statistique de test $\phantom{xxx}$ pour chacun de l'au moins un segment de

tension $s_i$, en fonction de ses valeurs de magnitude de pics PSD $P_k^i$ et de valeurs de référence $R_k$, chaque valeur de référence $R_k$ étant une magnitude d'un pic à la fréquence caractéristique $f_k$ de l'ensemble de pile à combustible (15) pendant un fonctionnement normal en régime permanent ;
une vérification (125) du fait que la statistique de test $T$ soit supérieure ou non à un seuil prédéterminé $\gamma$ :

si la statistique de test $T$ est inférieure ou égale au seuil prédéterminé $\gamma$, une reconnaissance (130') du fait que l'ensemble de pile à combustible (15) est en fonctionnement normal en régime permanent pendant le $i$-ème intervalle de temps correspondant ;
si la statistique de test $T^i$ est supérieure au seuil prédéterminé $\gamma$, une reconnaissance (130) du fait qu'un défaut et/ou une dégradation s'est produit(e) dans le système de pile à combustible pendant le $i$-ème intervalle de temps correspondant.

2.  Procédé selon la revendication 1, où l'étape (100) d'acquisition du signal de tension émis par l'ensemble de pile à combustible (15) utilise une fréquence d'échantillonnage non inférieure à 1/10 Hz, optionnellement égale à 1 Hz.

3.  Procédé selon la revendication 1 ou 2, où l'étape (101) d'identification (101) d'au moins un segment de tension $s_i$ est effectuée automatiquement par le biais d'Algorithmes de Détection de Changement (CDAs).

4.  Procédé selon l'une quelconque des revendications précédentes, où la longueur du $i$-ème intervalle de temps est telle que le segment de tension correspondant $s_i$ contient au moins 1000 échantillons.

5.  Procédé selon les revendications 2 et 4, où la fréquence d'échantillonnage est de 1 Hz et la longueur du $i$-ème intervalle de temps n'est pas inférieure à 1 h, optionnellement égale à 2h.

6.  Procédé selon l'une quelconque des revendications précédentes, où chacun de l'au moins un segment de tension redressé $s_i'$ est obtenu en soustrayant du segment de tension $s_i$ son Ajustement Linéaire par les Moindres Carrés, optionnellement par le biais d'une Première différenciation ou d'un filtrage Numérique.

7.  Procédé selon l'une quelconque des revendications précédentes, où les fréquences caractéristiques $f_k$ et les valeurs de référence $R_k$, $\forall k$, sont obtenues par estimation (120) d'un PSD d'un segment de tension redressé $s_j$ dans un $j$-ème intervalle de temps pendant lequel l'ensemble de pile à combustible est supposé être en fonctionnement normal

$$P_k^j = R_k$$

en régime permanent et par mesure (120) de son pic PSD $\phantom{xxx}$ et des fréquences de crête relatives $f_k$, avec $k=1,..., M, M \in N$ et $M \geq 1$.

8.  Procédé selon l'une quelconque des revendications 1 à 6, où les fréquences caractéristiques $f_k$ et les valeurs de référence $R_k$, $\forall k$, d'un ensemble spécifique de pile à combustible (15) sont préalablement obtenues par exécution d'étapes de l'acquisition (100) d'un signal de tension émis à l'estimation (120) du PSD sur l'ensemble de pile à combustible (15) fonctionnant en régime permanent après une période de réchauffement, quand il est supposé qu'aucun(e) défaut et/ou dégradation substantiel(le) ne s'est encore produit(e).

9.  Procédé selon l'une quelconque des revendications 1 à 6, où les fréquences caractéristiques $f_k$ et les valeurs de référence $R_k$, $\forall k$, d'un premier ensemble spécifique de pile à combustible (15) sont préalablement obtenues en effectuant des étapes de l'acquisition (100) d'une émission de signal de tension à l'estimation (120) du PSD sur un second ensemble de pile à combustible (15') fonctionnant en régime permanent après une période de réchauffement, lorsqu'il est supposé qu'aucun(e) défaut substantiel et/ou dégradation ne s'est encore produit(e), ledit second ensemble de pile à combustible (15') étant du même type que le premier ensemble de pile à combustible (15).

10.  Procédé selon l'une quelconque des revendications 1 à 6, où les fréquences caractéristiques $f_k$ et les valeurs de référence $R_k$, $\forall k$, d'un ensemble spécifique de pile à combustible (15) sont fournies par le fabricant.

**11.** Procédé selon l'une quelconque des revendications précédentes, où la statistique de test $T$ pour chacun de l'au moins un segment de tension $s_i$, est égale à $T_Q^i = \left.\sum_{k=1}^{Q} P_k^i \middle/ \sum_{k=1}^{Q} R_k\right.$, avec $Q \in N$ et $1 \le Q \le M$, où $Q$ est le nombre de pics considérés.

**12.** Procédé selon l'une quelconque des revendications 1 à 10, où la statistique de test $T$ pour chacun de l'au moins un segment de tension $s_i$, est égale à $T_g^i = g^i\left(T_{Q_1,Q_2}^i\right) = g\left(\left.\sum_{k=1}^{Q_1} \beta_k P_k^i \middle/ \sum_{h=1}^{Q_2} \rho_h R_h\right.\right)$ avec $Q_1$, $Q_2 \in N$, $1 \le Q_1$, $Q_2 \le M$, où $Q_1$, $Q_2$ sont les nombres de pics considérés dans le segment de tension et dans le régime permanent nominal, respectivement, tandis que $\beta_k$ et $\rho_h$ sont des coefficients multipliant ces valeurs de pic de PSD, et $g(\cdot)$ est une fonction inversible, optionnellement égale à $T_{Q_1,Q_2}^i = \left.\sum_{k=1}^{Q_1} \beta_k P_k^i \middle/ \sum_{h=1}^{Q_2} \rho_h R_h\right.$.

**13.** Procédé selon l'une quelconque des revendications 1 à 10, où la statistique de test $T$ pour chacun de l'au moins un segment de tension $s_i$, est égale à $T_{Q_1,Q_2}^i = \sum_{k=1}^{Q_1} \vartheta_k P_k^i - \sum_{h=1}^{Q_2} \varphi_h R_h$, avec $Q_1$, $Q_2 \in N$, $1 \le Q_1$, $Q_2 \le M$, où $Q_1$, $Q_2$ sont les nombres de pics considérés dans les segments de tension et dans le régime permanent nominal, respectivement, tandis que $\vartheta_k$ et $\varphi_h$ sont des coefficients multipliant ces valeurs de pics PSD.

**14.** Procédé selon l'une quelconque des revendications précédentes, où le seuil prédéterminé $\gamma$ est égal à un centile $1 - \alpha$ de la distribution empirique de la statistique de test $T$ calculée pour une pluralité d'opérations dans des conditions nominales, c'est-à-dire dans des opérations normales en régime permanent, optionnellement $\alpha$ étant égal à 0,05.

FIG. 1

Voltage time series

Close-up

FIG. 2

FIG. 3

a — Time interval of the segment no. 6: 160.4 h - 162.2 h. FU = 0.9

b — Time interval of the segment no. 4: 100.1 h - 121.2 h. FU = 0.8

c — Time interval of the segment no. 2: 50.2 h - 71.3 h. FU = 0.7

d — Time interval of the segment no. 1: 26.2 h - 47.3 h. FU = 0.6

EP 3 563 164 B1

## REFERENCES CITED IN THE DESCRIPTION

### Patent documents cited in the description

- US 7531253 B
- US 20140093802 A1
- US 20070172708 A1
- US 20070259256 A1
- WO 2013083873 A1
- US 20060078788 A1

### Non-patent literature cited in the description

- **ANONYMOUS.** *Design: Degradation Signatures Identification for Stack Operation Diagnostics,* 15 February 2016, 1-12, http://cordis.europa.eu/result/rcn/177527_en.pdf